# FASCICULE DE BREVET EUROPEEN

(11) **EP 2 810 299 B1**
(45) Date de publication et mention de la délivrance du brevet: **20.07.2016**
(21) Numéro de dépôt: 13712302.2
(22) Date de dépôt: 22.01.2013
(51) Int. Cl.: H01L 21/60, H01L 23/49, B23K 20/00, H01L 33/62, G06K 19/077

(54) **PROCÉDÉ D'ASSEMBLAGE D'UN ÉLÉMENT À PUCE MICRO-ÉLECTRONIQUE SUR UN ÉLÉMENT FILAIRE, INSTALLATION PERMETTANT DE RÉALISER L'ASSEMBLAGE**
VERFAHREN ZUR MONTAGE EINES ELEMENTS MIT EINEM MIKROELEKTRONISCHEN CHIP AUF EINEM DRAHTELEMENT UND VORRICHTUNG ZUR DURCHFÜHRUNG DIESER MONTAGE
METHOD FOR ASSEMBLING AN ELEMENT HAVING A MICROELECTRONIC CHIP ONTO A WIRE ELEMENT, AND EQUIPMENT FOR CARRYING OUT THE ASSEMBLY

(30) Priorité: 31.01.2012 FR 1200285
(43) Date de publication de la demande: 10.12.2014
(73) Titulaire: Commissariat à l'Énergie Atomique et aux Énergies Alternatives, 75015 Paris (FR)
(72) Inventeur: BRUN, Jean, F-38800 Champagnier (FR)
(74) Mandataire: Talbot, Alexandre
(86) Numéro de dépôt international: PCT/FR2013/000022
(87) Numéro de publication internationale: WO 2013/114009

(56) Documents cités:
- WO-A1-2011/161336
- JP-A- 2002 353 267
- US-A- 3 270 256
- US-A1- 2003 080 918
- US-A1- 2007 069 341

## Description

### Domaine technique de l'invention

L'invention est relative à un procédé d'assemblage d'un élément à puce micro-électronique sur un élément filaire électriquement conducteur.

### État de la technique

De nombreuses techniques existent aujourd'hui pour connecter mécaniquement et électriquement des éléments à puce micro-électronique entre eux. Une technique classique consiste, une fois les éléments à puce formés sur un substrat, et libérés par sciage, à réaliser une connexion mécanique rigide entre eux. Les éléments à puce, alors fixés sur un support rigide, sont ensuite connectés électriquement avant qu'un enrobage de protection ne soit formé. Cette approche, consistant à réaliser la connexion sur un support rigide, est classiquement utilisée lorsqu'il existe une grande complexité dans la connexion des éléments à puce. Cependant, cette dernière a pour principal inconvénient d'utiliser un support mécanique rigide qui est particulièrement mal adapté à une intégration dans des structures souples.

Le document WO2009/013409 de la demanderesse décrit l'utilisation d'une plaque de silicium sur laquelle sont réalisés des éléments à puce indépendants. Les éléments à puce sont reliés électriquement entre eux via un élément filaire avant d'être définitivement désolidarisés, tout est réalisé au niveau de la plaque de silicium, ce qui ne facilite pas la manipulation et l'association d'un élément à puce avec l'élément filaire.

Le document EP2390184 décrit une machine permettant de former une guirlande d'éléments à puce chacun équipés d'une rainure. L'élément filaire est alors encastré dans la rainure ce qui permet entre autre d'assurer sa protection.

Le document US2003/0080918 décrit une machine permettant de former une guirlande d'éléments à puce, mais ne divulgue pas une étape de mise sous tension.

### Résumé de l'invention

On cherche ainsi à faciliter la fabrication d'une guirlande munie d'éléments à puce micro-électronique et ce à faibles coûts.

On tend vers ce but en ce que le procédé comporte les étapes suivantes :
- prévoir un système de défilement de l'élément filaire entre un dispositif d'alimentation en élément filaire vers un dispositif de stockage dudit élément filaire,
- tendre l'élément filaire entre le dispositif d'alimentation et le dispositif de stockage par un dispositif de mise sous tension,
- prévoir un réservoir d'éléments à puce individualisés et désolidarisés, chaque élément à puce comprenant une borne de connexion, la borne de connexion de chaque élément à puce comprenant un sommet libre d'accès en regard duquel aucune partie de l'élément à puce n'est présente,
- amener un élément à puce à partir du réservoir dans une zone d'assemblage située entre les dispositifs d'alimentation et de stockage de sorte que l'élément filaire soit tendu dans ladite zone d'assemblage,
- fixer, dans la zone d'assemblage, l'élément filaire électriquement conducteur à la borne de connexion de l'élément à puce,
- réaliser un apport de matière électriquement isolante au niveau de l'élément à puce après sa fixation à l'élément filaire pour former un capot, ledit apport de matière étant réalisé sur la face de l'élément à puce comportant la borne de connexion fixée audit élément filaire de manière à recouvrir au moins la borne de connexion et une portion de l'élément filaire au niveau de la fixation.

Avantageusement, plusieurs éléments à puce sont amenés sélectivement à partir du réservoir les uns après les autres dans la zone d'assemblage de sorte à obtenir, après le passage d'une série d'éléments à puce dans la zone d'assemblage, une guirlande formée par la série d'éléments à puce fixés sur l'élément filaire et espacés le long de l'élément filaire.

Selon une réalisation, l'apport de matière destinée à former le capot est réalisé par une buse configurée pour réaliser un jet de la matière électriquement isolante.

L'étape de fixation d'un élément à puce à l'élément filaire est réalisée par collage ou par soudure.

Selon une variante, la borne de connexion de l'élément à puce comporte :
- un plot assurant la connexion électrique avec la puce de l'élément à puce,
- un matériau distinct dudit plot et recouvrant le sommet dudit plot,
et l'étape de fixation de l'élément filaire est réalisée par modification dudit matériau au sommet du plot pour assurer la fixation, et au moins partiellement le contact électrique entre le plot et l'élément filaire.

Avantageusement le matériau au sommet du plot mouille sur une surface extérieure de l'élément filaire au cours de l'étape de soudure.

Dans le cas où la fixation est réalisée par collage, le matériau au sommet du plot peut être un polymère chargé en particules électriquement conductrices, et l'étape de fixation comporte une sollicitation mécanique entre l'élément filaire et ledit polymère de sorte à le comprimer entre l'élément filaire et le plot pour assurer un contact électrique entre le plot et l'élément filaire par pincement d'une particule électriquement conductrice du polymère, ou d'un agglomérat de particules électriquement conductrices du polymère.

Avantageusement, lors de l'étape de fixation de l'élément filaire sur la borne de connexion, le maintien de l'élément filaire contre le matériau par sollicitation dudit élément filaire en direction du plot et l'échauffement de l'élément filaire pour ramollir le matériau.

L'apport de matière peut être calculé de sorte à homogénéiser, après fixation, le volume de l'ensemble formé par le capot, le segment de l'élément filaire noyé dans le capot et l'élément à puce autour de l'axe de l'élément filaire.

Selon une variante, l'étape d'apport de matière est réalisée avant de stocker l'élément filaire dans le dispositif de stockage, ou une étape de stockage de l'élément filaire, sur lequel est fixé au moins un élément à puce, dans le dispositif de stockage est réalisée avant l'étape d'apport de matière.

L'invention est aussi relative à une installation pour réaliser un assemblage d'un élément à puce micro-électronique sur un élément filaire électriquement conducteur, l'installation comporte :
- un réservoir contenant des d'éléments à puce individualisés et désolidarisés, chaque élément à puce comprenant une borne de connexion, la borne de connexion de chaque élément à puce comprenant un sommet libre d'accès en regard duquel aucune partie de l'élément à puce n'est présente,
- un système pour faire défiler un élément filaire à partir d'un dispositif d'alimentation en élément filaire vers un dispositif de stockage dudit élément filaire, de sorte que l'élément filaire passe dans une zone d'assemblage,
- un dispositif de mise sous tension de l'élément filaire entre le dispositif d'alimentation et le dispositif de stockage,
- un dispositif pour amener sélectivement un élément à puce à partir du réservoir dans la zone d'assemblage,
- un dispositif pour fixer, dans la zone d'assemblage, l'élément filaire à la borne de connexion dudit élément à puce,
- un dispositif pour déposer une matière électriquement isolante sur l'élément à puce après sa fixation à l'élément filaire de sorte à former un capot au niveau de la fixation entre l'élément filaire et la borne de connexion.

Le dispositif pour fixer peut comprendre un élément apte à échauffer l'élément filaire dans la zone d'assemblage pour réaliser la fixation.

Le dispositif pour déposer peut comporter une buse de projection configurée pour occuper une position de projection dans laquelle elle est disposée en regard de la face de l'élément à puce sur laquelle le capot doit être formé.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre une vue de dessus d'un élément à puce micro-electronique.
La figure 2 illustre une vue de côté d'un élément à puce micro-électronique selon la figure 1
La figure 3 illustre les différentes étapes d'un procédé permettant d'associer des éléments à puce à un élément filaire.
La figure 4 illustre une réalisation d'une machine permettant de mettre en oeuvre le procédé.
La figure 5 illustre en détail un élément filaire associé à un élément à puce recouvert d'un capot.
La figure 6 illustre un élément à puce d'un type particulier associé à un élément filaire.
La figure 7 illustre une variante d'élément à puce associé à deux éléments filaires distincts.

### Description de modes particuliers de réalisation

Comme on l'a précédemment indiqué, on cherche à réaliser avantageusement une guirlande à base d'une série d'éléments à puce micro-électronique (ou d'au moins un élément à puce) dont l'assemblage est solidifié par un apport de matière d'enrobage formant le capot.

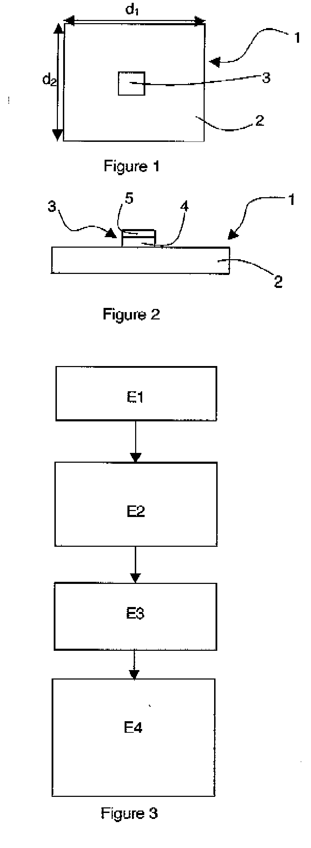

Un exemple d'élément à puce microélectronique utilisable dans le cadre de la présente invention est visible aux figures 1 et 2. Un tel élément à puce microélectronique 1 peut comporter une base 2, renfermant par exemple la puce ou constituant la puce, et une borne de connexion 3 avantageusement en saillie de la surface extérieure de la base 2.

Selon une réalisation particulière, la base 2 de l'élément à puce 1 se présente sous une forme sensiblement parallélépipédique. La borne de connexion 3 est en saillie d'une des faces de la base 2, avantageusement d'une face dite principale. La face principale est définie comme la face ayant les plus grandes dimensions latérales d₁ et d₂, autrement dit il s'agit de la face dont la surface est la plus grande. Dans le cadre d'un parallélépipède, la base 2 comporte deux faces principales opposées.

Afin de faciliter la production de la guirlande et de diminuer les coûts, l'élément à puce 1 comporte au moins une borne de connexion 3 dont l'accès est facilité, ou plusieurs bornes de connexion 3 dont l'accès est facilité. De manière générale, par « accès facilité » on entend un élément à puce tel que décrit ci-dessus en tant qu'exemple illustratif, ou sous une autre forme quelconque, au niveau duquel aucune partie de l'élément à puce 1 n'est en regard du sommet de la borne de connexion 3, ce qui laisse une liberté d'accès totale à la borne de connexion 3.

Avantageusement, chaque borne de connexion 3 d'un élément à puce 1 comporte un plot 4 assurant la connexion électrique avec la puce 2 de l'élément à puce 1. Un matériau 5, distinct dudit plot 4, recouvre au moins partiellement le sommet dudit plot 4. Le sommet est défini comme étant l'extrémité du plot 4 opposée à la base 2 sur laquelle est placé ledit plot 4. Ce matériau 5 distinct situé au sommet du plot 4 est destiné à faciliter et à améliorer le contact électrique avec un élément filaire associé à l'élément à puce 1.

Préférentiellement, hormis la borne de connexion 3 en saillie, la face de la base 2 portant ladite borne de connexion 3 est totalement libre (à l'exception d'éventuelle(s) borne(s) de connexion 3 supplémentaire(s)).

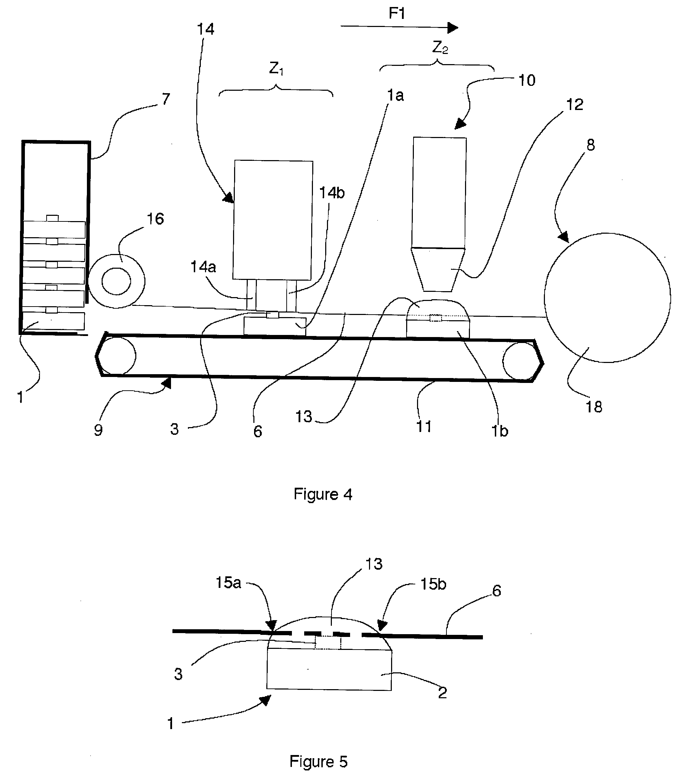

Le procédé illustré aux figures 3 et 4 est tout particulièrement adapté à l'assemblage d'un élément à puce 1 (préférentiellement d'un type tel que défini ci-dessus) sur un élément filaire 6 électriquement conducteur. Ainsi, le procédé peut comporter une étape E1 dans laquelle on prévoit un réservoir 7 d'éléments à puce 1 individualisés et désolidarisés. Chaque élément à puce comprend une borne de connexion 3, et la borne de connexion 3 de chaque élément à puce 1 comprend un sommet libre d'accès en regard duquel aucune partie de l'élément à puce 1 n'est présente. Par « individualisés et désolidarisés » on entend que les éléments à puce ne sont pas reliés les uns aux autres par quelque élément de solidarisation, par exemple du type support temporaire. Ce réservoir 7 peut, par exemple, contenir des éléments à puce 1 tels que décrits ci-dessus disposés en vrac ou ordonnés pour en faciliter la distribution. Ensuite, un élément à puce peut être amené (étape E2) à partir du réservoir 7 dans une zone d'assemblage Z₁ où un élément filaire 6 électriquement conducteur est fixé (étape E3) à la borne de connexion 3 de l'élément à puce 1 a. Cette connexion est bien entendue destinée à relier électriquement la puce de l'élément à puce 1 a à l'élément filaire 6. Pour réaliser le déplacement de l'élément filaire 6, on prévoit un système de défilement de l'élément filaire 6 entre un dispositif d'alimentation 16 en élément filaire 6 (par exemple une bobine) vers un dispositif de stockage 18 dudit élément filaire 6 (par exemple un système d'enroulement). Au cours du procédé, l'élément filaire 6 est tendu entre le dispositif d'alimentation 16 et le dispositif de stockage 18 par un dispositif de mise sous tension. La mise sous tension de l'élément filaire peut être appliquée depuis le dispositif d'alimentation jusqu'au dispositif de stockage ou dans une zone particulière du chemin de défilement entre des deux points. Il est également possible d'avoir des tensions différentes d'élément filaire le long du chemin de défilement.

La mise sous tension peut être réalisée , selon un exemple ne faisant pas partie de l'invention revendiquée, par les dispositifs d'alimentation et de stockage 16, 18 eux même, ou, selon les revendications, par tout type de mise sous tension d'un élément filaire entre deux points pouvant être mis en oeuvre par l'homme du métier. La zone d'assemblage Z₁ est située entre les dispositifs d'alimentation 16 et de stockage 18 de sorte que l'élément filaire 6 y soit tendu. Selon l'invention, l'élément filaire est rectiligne dans la zone d'assemblage Z₁ pour faciliter la fixation de l'élément à puce.

Dans une variante de réalisation, l'élément filaire est rectiligne entre le dispositif d'alimentation et le dispositif de stockage, mais il est également possible d'avoir un défilement représentant des lignes brisées, l'élément filaire étant rectiligne dans la zone d'assemblage Z₁.

Avantageusement, l'élément filaire 6 fixé à l'élément à puce 1 sera destiné à être incorporé à un tissu, ou dans d'autres systèmes, nécessitant sa manipulation. Ainsi, les protubérances de l'assemblage peuvent accrocher et générer des problèmes notamment de casse au niveau de l'élément à puce 1 au cours de la manipulation. Ainsi, il résulte une problématique d'amélioration de la fixation. Cette problématique peut être résolue en réalisant un apport (étape E4 de la figure 3) de matière électriquement isolante au niveau de l'élément à puce 1 b après sa fixation à l'élément filaire 6 pour former un capot 13, ledit apport de matière étant réalisé sur la face de l'élément à puce 1 comportant la borne de connexion 3 fixée audit élément filaire 6 de manière à recouvrir au moins la borne de connexion 3 et une portion de l'élément filaire 6 au niveau de la fixation (c'est-à-dire la zone où l'élément filaire 6 est solidarisé à la borne de connexion 3). Cette matière est électriquement isolante car elle évitera les courts-circuits au niveau de la borne de connexion 3, notamment dans le cas où une même face destinée à recevoir la matière comporterait plusieurs bornes de connexion 3. Cet apport de matière est assimilable à un enrobage au moins partiel de l'élément à puce 1 correspondant. Il permet entre autres de former un capot de protection, de forme avantageusement arrondie, de la fixation. Outre la notion de protection, le capot 13 permet de solidifier l'assemblage entre l'élément filaire 6 et l'élément à puce 1 associé. Avantageusement, le capot 13 recouvre toute la surface libre de la face portant, la (ou les) borne(s) de connexion et l'élément filaire au niveau de sa fixation à la borne de connexion. Dans cette configuration, le capot 13 présente avantageusement une surface extérieure convexe limitant l'accroche avec un élément extérieur lors de la manipulation de la guirlande.

Ce procédé peut être mis en oeuvre par une installation permettant de réaliser un assemblage d'un élément à puce micro-électronique 1 sur un élément filaire 6 électriquement conducteur telle qu'illustrée à la figure 4 et comprenant le réservoir 7 contenant des éléments à puce 1 individualisés et désolidarisés les uns des autres du type décrit ci-avant, un système pour faire défiler 8, selon l'invention de manière tendue, un élément filaire 6 dans une zone d'assemblage Z₁, un dispositif 9 pour amener sélectivement un élément à puce 1 a à partir du réservoir dans la zone d'assemblage Z₁ pour l'assembler à l'élément filaire 6, un dispositif 14 pour fixer l'élément filaire 6 à une borne de connexion 3 de l'élément à puce 1 a situé dans la zone Z₁, et un dispositif 10 pour déposer une matière électriquement isolante sur l'élément à puce 1 b après sa fixation à l'élément filaire 6, réalisant ainsi l'enrobage décrit ci-dessus de sorte à former le capot 13 au niveau de la fixation entre l'élément filaire 6 et la borne de connexion 3.

Afin de réaliser la tension de l'élément filaire 6 dans la zone d'assemblage Z₁, l'installation comporte un dispositif de mise sous tension de l'élément filaire entre le dispositif d'alimentation et le dispositif de stockage. Ainsi, entre le dispositif d'alimentation 16 et le dispositif de stockage 18, l'élément filaire 6 passe dans la zone d'assemblage Z₁ de manière tendue. Le système de défilement 8 permet le défilement de l'élément filaire 6 à partir du dispositif d'alimentation 16 en élément filaire 6 vers le dispositif de stockage 18 dudit élément filaire 6, de sorte que l'élément filaire 6 passe dans la zone d'assemblage Z₁.

Selon un exemple ne faisant pas partie de l'invention revendiquée, le dispositif de mise sous tension peut être directement formé par les dispositifs d'alimentation 16 et de stockage 18 qui sont alors configurés pour réaliser la tension. Il en va de même pour le système de défilement qui peut aussi être formé par les dispositifs d'alimentation 16 et de stockage 18 qui sont alors configurés pour réaliser le défilement. Il est également possible d'avoir un dispositif de mise sous tension qui ne fait pas intervenir le dispositif d'alimentation, par exemple au moyen d'un organe intermédiaire qui frotte sur l'élément filaire afin d'assurer la mise sous tension ou au moyen d'une roue autour de laquelle l'élément filaire est enroulé.

Dans encore une autre variante de réalisation, le dispositif de mise sous tension peut être réalisé sans le dispositif de stockage, par exemple au moyen d'une roue intermédiaire. Le dispositif de stockage peut être une roue ou un réservoir.

Sur la figure 4, le réservoir 7 se présente sous la forme d'un élément dans lequel une pluralité d'éléments à puce 1 sont empilés. L'élément à puce 1 du bas de la pile étant le premier à sortir du réservoir 7 afin que les étapes subséquentes du procédé soient appliquées.

Le dispositif 9 pour amener sélectivement un élément à puce dans la zone d'assemblage peut se présenter sous la forme d'un convoyeur équipé d'un bandeau 11 rotatif en forme de boucle. Bien entendu, il peut aussi se présenter sous la forme d'un bras apte à sélectionner un élément à puce du réservoir 7 et à le disposer dans la zone d'assemblage Z₁. L'homme du métier pourra rajouter tout type de dispositif 9 idoine.

Dans le mode de réalisation décrit ci-dessus, on a donné l'exemple général d'un élément à puce 1 fixé à un élément filaire 6. Bien entendu, l'homme du métier peut selon le même principe fixer une pluralité d'éléments à puce 1 sur un même élément filaire 6 de sorte à former une guirlande d'éléments à puce 1. Autrement dit, plusieurs éléments à puce 1 peuvent être amenés sélectivement à partir du réservoir 7 les uns après les autres dans la zone d'assemblage Z₁ de sorte à obtenir, après le passage d'une série d'éléments à puce dans la zone d'assemblage Z₁, une guirlande formée par la série d'éléments à puce 1 fixés sur l'élément filaire 6 et espacés le long de l'élément filaire 6. L'espacement peut être réalisé à la demande en fonction des besoins de l'homme du métier.

Dans le procédé et/ou l'installation, l'apport de matière électriquement isolante pour former le capot 13 peut être réalisé par une buse 12 configurée pour réaliser un jet de ladite matière électriquement isolante. Autrement dit, le dispositif 10 peut comporter une buse de projection 12 configurée pour occuper une position de projection dans laquelle elle est disposée en regard de la face de l'élément à puce sur laquelle le capot 13 doit être formé. Sur la figure 4, cette buse 12 du dispositif 10 permet de déposer par projection la matière électriquement isolante sur l'élément à puce 1 b, après sa fixation à l'élément filaire 6 visée ci-dessus, par exemple dans une zone Z₂ d'enrobage en aval de la zone Z₁ selon le sens F₁ de défilement de l'élément filaire 6. La buse est avantageuse car elle permet de contrôler avec précision la quantité de matière électriquement isolante projetée pour former le capot 13. Bien entendu, l'homme du métier pourra remplacer la buse 12 par tout dispositif idoine comme par exemple un tampon configuré pour occuper sélectivement deux positions. Dans une première position le tampon vient prélever la matière au niveau d'une source de matière, et dans une seconde position le tampon vient en contact avec l'élément à puce 1 b dans la zone Z₂ pour y déposer la matière et former le capot 13.

Dans les différents cas, la matière est avantageusement dans un état liquide, ou visqueux, au moment de son apposition, puis passe à un état solide pour solidifier l'assemblage de l'élément filaire et de l'élément à puce, et ainsi former le capot 13.

Cette apposition de matière permet de réaliser un ensemble formé par la matière solidifiée formant capot 13, l'élément à puce 1, et un segment d'élément filaire 6 noyé dans le capot 13. Avantageusement, la quantité de matière apposée est calculée de sorte à homogénéiser/recentrer le volume de l'ensemble autour de l'axe de l'élément filaire 6. Ceci permet avantageusement de tendre vers une symétrie axiale des formes extérieures de l'ensemble pour, par exemple, faciliter le guipage de l'élément filaire au niveau de sa fixation avec un élément à puce 1 ou la manipulation de la guirlande. Autrement dit, sur la figure 5, avantageusement, l'élément filaire 6 sort du capot 13 au niveau de deux points opposés 15a, 15b. Ces deux points 15a, 15b forment virtuellement une droite comprise dans un premier plan sensiblement parallèle au plan de la face de la base 2 de l'élément à puce 1 portant la ou les bornes de connexion 3 associée(s). Avantageusement, le volume de l'assemblage formé par l'élément à puce 1, le capot 13 et le segment de l'élément filaire 6 encapsulé par le capot 13 est réparti de manière homogène de part et d'autre du premier plan et avantageusement de part et d'autre d'un second plan perpendiculaire au premier plan et comportant lui aussi la droite virtuelle.

Avantageusement, l'étape de fixation d'un élément à puce à l'élément filaire est réalisée par collage ou par soudure. Ainsi, le dispositif 14 pour fixer l'élément filaire 6 peut être un poste à souder ou un poste à collage.

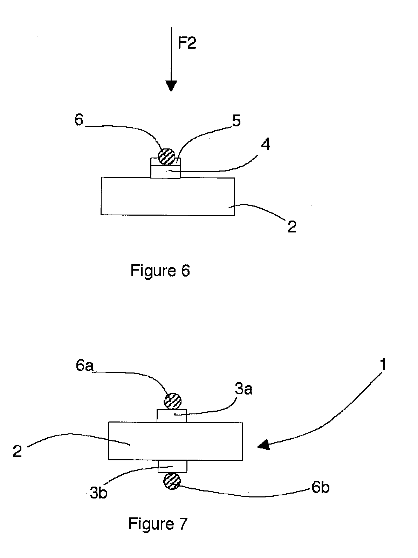

Dans le cas où le sommet du plot 4 de la, ou de chaque, borne de connexion 3 du, ou de chaque, élément à puce 1 est recouvert par un matériau 5 distinct dudit plot 4 (figure 2), l'étape de fixation de l'élément filaire 6 peut être réalisée par modification dudit matériau 5 assurant, après fixation, au moins partiellement, le contact électrique entre le plot 4 et l'élément filaire 6 (figure 6) et la fixation de l'élément filaire 6 au plot 4.

Dans la variante utilisant la fixation par soudure en combinaison avec le plot 4, et dont le sommet est recouvert par un matériau 5 distinct du plot 4, le matériau 5 au sommet du plot 4 mouille sur une surface extérieure de l'élément filaire 6 au cours de l'étape de soudure, et vient fixer après refroidissement l'élément filaire 6 à la borne de connexion 3 tout en assurant le contact électrique.

Dans la variante par collage en combinaison avec le plot 4 dont le sommet est recouvert par un matériau 5 distinct du plot 4, le matériau 5 au sommet du plot 4 est un polymère chargé en particules électriquement conductrices. Dans ce cas, l'étape de fixation comporte une sollicitation mécanique (flèche F₂ de la figure 6) entre l'élément filaire 6 et ledit matériau 5 de sorte à comprimer ledit matériau 5 entre l'élément filaire 6 et le plot 4 pour assurer un contact électrique entre le plot 4 et l'élément filaire 6 par pincement d'une particule électriquement conductrice du matériau 5, ou d'un agglomérat de particules électriquement conductrices du matériau 5. Un agglomérat correspond alors à un ensemble de particules solidaires électriquement entre elles. Avantageusement, le polymère assure aussi la fixation de l'élément filaire 6 au plot 4.

Parmi les types de polymères envisageables dans le cadre du mode de réalisation ci-dessus il est possible d'utiliser des colles conductrices anisotropiques. Les polymères pourront alors être de type film anisotropique conducteur (ACF pour « Anisotropic Conductive Film » en anglais), adhésif anisotropique conducteur (ACA pour « Anisotropic Conductive Adhesive » en anglais), adhésif isotropique conducteur (ICA pour «Isotropic Conductive Adhesive » en anglais).

Selon une réalisation applicable à la soudure ou au collage dans la variante avec le matériau 5 recouvrant le sommet du plot 4, lors de l'étape de fixation de l'élément filaire 6 sur la borne de connexion 3, l'élément filaire 6 est maintenu, par sollicitation en direction du plot 4, contre le matériau 5, avantageusement en phase solide, et est échauffé pour réaliser la fixation, par ramollissement dudit matériau 5 grâce à la chaleur obtenue par l'échauffement entre l'élément filaire 6 et le plot 4. Après ramollissement et établissement du contact électrique, le matériau peut être refroidi pour fixer l'assemblage, avantageusement le maintien est conservé lors du refroidissement pour figer l'assemblage. Dans l'installation, ceci peut par exemple être mis en oeuvre par un élément 14a, 14b apte à échauffer l'élément filaire 6 dans la zone d'assemblage Z₁ au moment de la fixation, ainsi l'élément 14a, 14b peut faire partie du dispositif pour fixer 14. Par exemple un élément apte à échauffer peut être du type laser, four à infrarouge, induction, etc. Avantageusement, l'élément 14a 14b servant à échauffer l'élément filaire 6 permet aussi de solliciter l'élément filaire 6 en direction du plot 4 en prenant appui contre ledit élément filaire 6.

À la figure 4, la zone d'assemblage Z₁ est distincte de la zone d'enrobage Z₂. Cette réalisation permet d'augmenter la cadence dans la mesure où lorsqu'un élément à puce 1 b subit l'étape d'enrobage, l'élément à puce 1 a suivant subit l'étape de fixation. Bien entendu, les zones d'assemblage et d'enrobage peuvent aussi être commune, dans ce cas particulier le dispositif pour fixer 14 (et avantageusement l'élément 14a, 14b destiné à échauffer l'élément filaire 6) et le dispositif 10 pour déposer la matière d'enrobage sont escamotables l'un par rapport à l'autre pour permettre soit le travail de l'un, soit le travail de l'autre, dans la zone commune.

L'élément filaire 6 est avantageusement toujours en tension. De plus, la mise sous tension de l'élément filaire 6 permet d'éviter que ce dernier s'emmêle et facilite la gestion de la distance entre deux éléments à puce 1 fixés sur même un élément filaire 6. En outre, la mise sous tension permet de faciliter le déplacement de l'élément à puce 1 consécutivement à son association avec l'élément filaire 6. Autrement dit, dans l'exemple de la figure 4, les éléments à puce peuvent être amenés dans la zone d'assemblage Z₁ par un premier convoyeur 9, une fois la fixation réalisée, l'élément à puce 1 peut quitter le premier convoyeur (c'est-à-dire ne plus être en contact avec le premier convoyeur), et c'est l'élément filaire 6 qui joue le rôle de second convoyeur pour amener, par exemple, l'élément à puce 1 au niveau de la zone d'enrobage Z₂. Selon l'installation de la figure 4 et ses variantes, la tension continue de l'élément filaire peut être mise en oeuvre en faisant coopérer d'une part une bobine 16 d'alimentation en élément filaire 6 avec un système d'enroulement 18 en fin de chaîne d'assemblage. Le système d'enroulement 18 agit, par exemple, comme une unité de stockage d'une guirlande d'éléments à puce sous forme enroulée pour éviter que l'élément filaire 6 ne s'emmêle. De plus, comme l'élément filaire 6 équipé de ses différents éléments à puce est sous forme enroulée, le système d'enroulement 18 peut, à la fin de la chaîne d'assemblage, être désolidarisé de l'installation pour être directement réutilisé en tant que bobine d'alimentation dans une autre installation configurée pour manipuler la guirlande.

Il a été décrit ci-dessus un élément à puce muni d'une borne de connexion, bien entendu, l'élément à puce peut comporter au moins deux bornes de connexions selon les raffinements évoqués ci-dessus. Ainsi, il est possible d'associer à chaque borne de connexion un élément filaire distinct pour, par exemple, assurer le transit de données ou encore l'acheminement d'une source de courant pour alimenter les éléments à puce. Avantageusement, la ou les bornes de connexions seront situées sur une même face (préférentiellement principale) de la base de l'élément à puce. Selon une variante une ou des bornes de connexion pourront être situées sur des faces distinctes (avantageusement des faces principales opposés) de l'élément à puce, chaque face portant une borne de connexion étant, lors du procédé, recouverte au moins partiellement par apport de la matière d'enrobage de sorte à former deux capots distincts, ou un enrobage total de l'élément à puce formant un unique capot.

Dans le cadre de l'utilisation de plusieurs éléments filaires, l'homme du métier comprendra que les dispositifs de l'installation, notamment pour assurer l'étape de fixation et d'enrobage, seront adaptés à la situation.

Selon une variante illustrée à la figure 7, l'élément à puce 1 comporte deux bornes de connexion 3a, 3b telles que décrites ci-dessus et disposées sur deux faces opposées de la base 2 de l'élément à puce 1. De préférence, ces deux faces opposées sont des faces principales comme défini précédemment. Dès lors, l'étape de fixation peut comprendre la fixation de deux éléments filaires (avantageusement parallèles) 6a, 6b respectivement sur la première borne 3a et sur la seconde borne 3b, puis l'apport de matière destinée à former le capot peut être réalisé en deux temps au niveau d'une des deux faces puis de l'autre face. Cet assemblage permet avantageusement de mieux répartir le volume autour des deux éléments filaires 6a, 6b.

Les éléments à puce peuvent comporter des composants RFID, ou des diodes destinées à générer de la lumière, en vue de former respectivement un tissu intelligent, ou un tissu apte à afficher des motifs ou de l'information par éclairage.

Le capot 13 permet en outre d'améliorer la résistance à l'humidité de l'élément à puce 1, dans ce cas l'élément à puce 1 est avantageusement entièrement enrobé par le matériau destiné à former le capot 13 dans la zone Z₂ d'enrobage.

Selon une variante non représentée de réalisation de la zone d'enrobage, après fixation, l'élément à puce est présenté dans la zone d'enrobage par sa face comportant la borne de connexion fixée à l'élément filaire pour faire face à une réserve de liquide destiné à former le capot. L'élément à puce est alors approché du liquide de sorte que ce dernier vienne mouiller au niveau de l'élément filaire et remonter jusqu'à la face de la base portant la borne de connexion pour réaliser l'étape d'apport de matière.

Les éléments à puce seront présentés avantageusement les uns après les autres dans la zone d'assemblage à une cadence permettant leur fixation à l'élément filaire compatible avec la vitesse de défilement dudit élément filaire pour assurer un espacement idoine des éléments à puce fixés audit élément filaire.

Avantageusement, au niveau de l'élément à puce, l'élément filaire est partiellement noyé.

Dans le procédé, la réalisation d'un capot au niveau de l'élément à puce permet de réaliser un enrobage sélectif de chaque puce de la guirlande. Ceci permet de conserver une souplesse de l'élément filaire de part et d'autre de l'élément à puce concerné pour notamment faciliter le guipage de la guirlande (dans ce cas, la matière électriquement isolante formant capot 13 n'enrobe avantageusement pas l'élément filaire 6 entre deux élément à puce adjacents du fait du dépôt sélectif sur l'élément à puce), ou tout autre type d'utilisation future de la guirlande. De plus, le fait de sélectionner la face munie de la borne de connexion et sur laquelle sera directement apposée la matière d'enrobage permet de réduire les coûts de fabrication.

Il a été décrit ci-avant, pour favoriser la fixation de l'élément filaire à la borne de connexion, l'utilisation d'une borne de connexion munie d'un plot et d'un matériau distinct, destiné à faciliter et à améliorer le contact électrique, disposé au sommet du plot. Selon une variante, la borne de connexion peut être constituée uniquement du plot et le matériau distinct peut faire soit partie intégrante de l'élément filaire qui comporte alors une âme recouverte par le matériau distinct, soit il peut être déposé localement sur l'élément filaire avant l'étape de fixation. Dès lors, au cours de l'étape de fixation associée au matériau distinct déposé localement sur l'élément filaire, la portion d'élément filaire munie de ce dépôt local est amenée en regard du plot de l'élément à puce à fixer, et ce dépôt local est mis en contact avec le sommet du plot lors de la fixation. Les différents modes de réalisation associés au matériau distinct destiné à faciliter et à améliorer le contact électrique évoqué ci-dessus s'appliquent à cette variante.

Selon une variante non représentée, l'élément filaire peut être fixé à la borne de connexion par soudure à ultrason ou par frottements.

Selon la figure 4, l'étape d'apport de matière est réalisée avant de stocker l'élément filaire 6 dans le dispositif de stockage 18. Cependant, selon une variante, en fonction des vitesses de défilement de l'élément filaire 6, des temps de traitement dans la zone d'assemblage et dans la zone d'enrobage, il peut être avantageux de réaliser un stockage intermédiaire entre les zones d'assemblage et d'enrobage. Ainsi, il peut être réalisé une étape de stockage de l'élément filaire 6, sur lequel est fixé au moins un élément à puce 1, dans le dispositif de stockage 18 avant l'étape d'apport de matière.

## Revendications

1. Procédé d'assemblage d'un élément à puce micro-électronique (1) sur un élément filaire (6) électriquement conducteur, **caractérisé en ce qu'**il comprend les étapes suivantes :
• prévoir le défilement de l'élément filaire (6) entre un dispositif d'alimentation (16) en élément filaire vers un dispositif de stockage (18) dudit élément filaire (6),
• tendre l'élément filaire entre le dispositif d'alimentation (16) et le dispositif de stockage (18) par un dispositif de mise sous tension (16, 18),
• prévoir (E1) un réservoir (7) d'éléments à puce (1) individualisés et désolidarisés, chaque élément à puce (1) comprenant une borne de connexion (3), la borne de connexion (3) de chaque élément à puce (1) comprenant un sommet libre d'accès en regard duquel aucune partie de l'élément à puce (1) n'est présente,
• amener (E2) un élément à puce (1) à partir du réservoir (7) dans une zone d'assemblage (Z1) située entre les dispositifs d'alimentation (16) et de stockage (18) de sorte que l'élément filaire (6) soit tendu dans ladite zone d'assemblage (Z1),
• fixer (E3), dans la zone d'assemblage (Z1), l'élément filaire (6) électriquement conducteur à la borne de connexion (3) de l'élément à puce (1),
• réaliser un apport de matière électriquement isolante au niveau de l'élément à puce (1) après sa fixation à l'élément filaire (6) pour former un capot (13), ledit apport de matière étant réalisé sur la face de l'élément à puce (1) comportant la borne de connexion (3) fixée audit élément filaire (6) de manière à recouvrir au moins la borne de connexion (3) et une portion de l'élément filaire (6) au niveau de la fixation.

2. Procédé selon la revendication 1, **caractérisé en ce que** plusieurs éléments à puce (1) sont amenés sélectivement à partir du réservoir (7) les uns après les autres dans la zone d'assemblage (Z₁) de sorte à obtenir, après le passage d'une série d'éléments à puce (1) dans la zone d'assemblage (Z₁), une guirlande formée par la série d'éléments à puce (1) fixés sur l'élément filaire (6) et espacés le long de l'élément filaire (6).

3. Procédé selon l'une des revendications 1 à 2, **caractérisé en ce que** l'apport de matière destinée à former le capot (13) est réalisé par une buse (12) configurée pour réaliser un jet de la matière électriquement isolante.

4. Procédé selon l'une des revendications précédentes, **caractérisé en ce que** l'étape de fixation d'un élément à puce (1) à l'élément filaire (6) est réalisée par collage.

5. Procédé selon l'une des revendications 1 à 3, **caractérisé en ce que** l'étape de fixation d'un élément à puce (1) à l'élément filaire (6) est réalisée par soudure.

6. Procédé selon l'une des revendications précédentes, **caractérisé en ce que** la borne de connexion (3) de l'élément à puce (1) comporte :
- un plot (4) assurant la connexion électrique avec la puce de l'élément à puce (1),
- un matériau (5) distinct dudit plot (4) et recouvrant le sommet dudit plot (4), et **en ce que** l'étape de fixation de l'élément filaire (6) est réalisée par modification dudit matériau (5) au sommet du plot (4) pour assurer la fixation, et au moins partiellement le contact électrique entre le plot (4) et l'élément filaire (6).

7. Procédé selon les revendications 5 et 6, **caractérisé en ce que** le matériau (5) au sommet du plot (4) mouille sur une surface extérieure de l'élément filaire (6) au cours de l'étape de soudure.

8. Procédé selon les revendications 4 et 6, **caractérisé en ce que** le matériau (5) au sommet du plot (4) est un polymère chargé en particules électriquement conductrices, et **en ce que** l'étape de fixation comporte une sollicitation mécanique (F2) entre l'élément filaire (6) et ledit polymère de sorte à le comprimer entre l'élément filaire (6) et le plot (4) pour assurer un contact électrique entre le plot (4) et l'élément filaire (6) par pincement d'une particule électriquement conductrice du polymère, ou d'un agglomérat de particules électriquement conductrices du polymère.

9. Procédé selon l'une des revendications 7 ou 8, **caractérisé en ce qu'**il comprend, lors de l'étape de fixation de l'élément filaire (6) sur la borne de connexion (3), le maintien de l'élément filaire (6) contre le matériau (5) par sollicitation dudit élément filaire (6) en direction du plot (4) et l'échauffement de l'élément filaire (6) pour ramollir le matériau (5).

10. Procédé selon l'une quelconque des revendications précédentes **caractérisé en ce que** l'apport de matière est calculé de sorte à homogénéiser, après fixation, le volume de l'ensemble formé par le capot (13), le segment de l'élément filaire (6) noyé dans le capot (13) et l'élément à puce (1) autour de l'axe de l'élément filaire (6).

11. Procédé selon l'une quelconque des revendications précédentes **caractérisé en ce que** l'étape d'apport de matière est réalisée avant de stocker l'élément filaire (6) dans le dispositif de stockage (18).

12. Procédé selon l'une quelconque des revendications 1 à 10 **caractérisé en**
**ce qu'**une étape de stockage de l'élément filaire (6), sur lequel est fixé au moins un élément à puce (1), dans le dispositif de stockage (18) est réalisée avant l'étape d'apport de matière.

13. Installation pour réaliser un assemblage d'un élément à puce micro-électronique (1) sur un élément filaire (6) électriquement conducteur, **caractérisée en ce qu'**elle comporte :
- un réservoir (7) contenant des d'éléments à puce (1) individualisés et désolidarisés, chaque élément à puce comprenant une borne de connexion (3), la borne de connexion (3) de chaque élément à puce (1) comprenant un sommet libre d'accès en regard duquel aucune partie de l'élément à puce (1) n'est présente,
- un système (8) pour faire défiler un élément filaire (6) à partir d'un dispositif d'alimentation (16) en élément filaire (6) vers un dispositif de stockage (18) dudit élément filaire (6), de sorte que l'élément filaire (6) passe dans une zone d'assemblage (Z1),
- un dispositif (9) pour amener sélectivement un élément à puce (1) à partir du réservoir (7) dans la zone d'assemblage (Z₁),
- un dispositif (14) pour fixer, dans la zone d'assemblage (Z1), l'élément filaire (6) à la borne de connexion (3) dudit élément à puce (1),
- un dispositif (10) pour déposer une matière électriquement isolante sur l'élément à puce (1) après sa fixation à l'élément filaire (6) de sorte à former un capot (13) au niveau de la fixation entre l'élément filaire (6) et la borne de connexion (3),
**caractérisé en ce que** l'installation comprend un dispositif de mise sous tension de l'élément filaire (6) pour tendre l'élément filaire entre le dispositif d'alimentation (16) et le dispositif de stockage (18).

14. Installation selon la revendication 13, caractérisée en ce le dispositif (14) pour fixer comprend un élément (14a,14b) apte à échauffer l'élément filaire (6) dans la zone d'assemblage (Z1) pour réaliser la fixation.

15. Installation selon l'une des revendications 13 à 14, **caractérisée en ce que** le dispositif (10) pour déposer comporte une buse de projection (12) configurée pour occuper une position de projection dans laquelle elle est disposée en regard de la face de l'élément à puce (1) sur laquelle le capot (13) doit être formé.

## Patentansprüche

1. Verfahren zum Verbinden eines Elements mit Mikroelektronikchip (1) mit einem elektrisch leitenden Drahtelement (6), **dadurch gekennzeichnet, dass** es die folgenden Schnitte umfasst:
• Vorsehen des Ablaufens des Drahtelements (6) von einer Drahtelementzuführvorrichtung (16) in Richtung einer Vorrichtung zum Lagern (18) des Drahtelements (6),
• Spannen des Drahtelements zwischen der Zuführvorrichtung (16) und der Lagervorrichtung (18) mittels einer Spannvorrichtung (16, 18),
• Vorsehen (E1) eines Behälters (7) mit vereinzelten und getrennten Chip-Elementen (1), wobei jedes Chip-Element (1) eine Anschlussklemme (3) umfasst, wobei die Anschlussklemme (3) eines jeden Chip-Elements (1) einen frei zugänglichen Scheitel aufweist, gegenüber dem kein Teil des Chip-Elements (1) vorhanden ist,
• Zufuhren (E2) eines Chip-Elements (1) aus dem Behälter (7) in einen Verbindungsbereich (Z1), der zwischen der Zuführvorrichtung (16) und der Lagervorrichtung (18) gelegen ist, so dass das Drahtelement (6) in dem Verbindungsbereich (Z1) gespannt ist,
• Befestigen (E3) des elektrisch leitenden Drahtelements (6) in dem Verbindungsbereich (Z1) an der Anschlussklemme (3) des Chip-Elements (1),
• Vollziehen eines Zuführens von elektrisch isolierendem Material im Bereich des Chip-Elements (1) nach seiner Befestigung an dem Drahtelement (6), um eine Kappe (13) auszubilden, wobei die Materialzufuhr auf der Seite des Chip-Elements (1) vollzogen wird, die die an dem Drahtelement (6) befestigte Anschlussklemme (3) umfasst, um wenigstens die Anschlussklemme (3) und einen Abschnitt des Drahtelements (6) im Bereich der Befestigung zu bedecken.

2. Verfahren nach Anspruch 1, **dadurch gekennzeichnet, dass** mehrere Chip-Elemente (1) aus dem Behälter (7) selektiv nacheinander in den Verbindungsbereich (Z1) zugeführt werden, um - nachdem eine Reihe von Chip-Elementen (1) den Verbindungsbereich (Z1) durchlaufen hat - eine Kette zu erhalten, die durch die Reihe von an dem Drahtelement (6) befestigten und entlang des Drahtelements (6) beabstandeten Chip- Elementen (1) gebildet ist.

3. Verfahren nach einem der Ansprüche 1 bis 2, **dadurch gekennzeichnet, dass** das Zuführen von Material, das dazu bestimmt ist, die Kappe (13) zu bilden, mittels einer Düse (12), die dazu ausgelegt ist, einen Strahl aus dem elektrisch isolierenden Material auszubilden, vollzogen wird.

4. Verfahren nach einem der vorhergehenden Ansprüche, **dadurch gekennzeichnet, dass** der Schritt des Befestigen eines Chip-Elements (1) an dem Drahtelement (6) durch Kleben vollzogen wird.

5. Verfahren nach einem der Anspruch 1 bis 3, **dadurch gekennzeichnet, dass** der Schritt des Befestigens eines Chip-Elements (1) an dem Drahtelement (6) durch Schweißen vollzogen wird.

6. Verfahren nach einem der vorhergehenden Ansprüche, dadurch gekennzeichet, dass die Anschlussklemme (3) des Chip-Elements (1) umfasst:
- einen Pin (4), der die elektrische Verbindung mit dem Chip des Chip-Elements (1) sicherstellt,
- ein Material (5), das von dem Pin (4) verschieden ist und das den Scheitel des Pins (4) bedeckt,
und dass der Schritt des Befestigens des Drahtelements (6) durch Modifikation des Materials (5) am Scheitel des Pins (4) vollzogen wird, um die Befestigung und wenigstens teilweise den elektrischen Kontakt zwischen dem Pin (4) und dem Drahtelement (6) sicherzustellen.

7. Verfahren nach den Ansprüchen 5 und 6, **dadurch** gekenntzeichnet, dass das Material (5) am Scheitel des Pins (4) sich auf einer Außenfläche des Drahtelements (6) im Laufe des Schweißschrittes ausbreitet.

8. Verfahren nach den Ansprüchen 4 und 6, **dadurch gekennzeichnet, dass** das Material (5) am Scheitel des Pins (4) ein mit elektrisch leitenden Partikeln beladenes Polymer ist und dass der Befestigungsschritt eine mechanische Beanspruchung (F2) zwischen dem Drahtelement (6) und dem Polymer umfasst, um es zwischen dem Drahtelement (6) und dem Pin (4) zu komprimieren, um einen elektrischen Kontakt zwischen dem Pin (4) und dem Drahtelement (6) durch Quetschen eines elektrisch leitenden Partikels des Polymers oder eines Agglomerats von elektrisch leitenden Partikeln des Polymers sicherzustellen.

9. Verfahren nach einem der Ansprüche 7 oder 8, **dadurch gekennzeichnet, dass** es während des Schrittes des Befestigens des Drahtelements (6) an der Anschlussklemme (3) das Halten des Drahtelements (6) an dem Material (5) durch Belastung des Drahtelements (6) in Richtung des Pins (4) sowie das Erhitzen des Drahtelements (6) zum Erweichen des Materials (5) umfasst.

10. Verfahren nach einem der vorhergehenden Ansprüche, **dadurch gekennzeichnet, dass** die Materialzufuhr derart berechnet ist, dass nach dem Befestigen das Volumen der Anordnung, welche durch die Kappe (13), das in die Kappe (13) eingebettete Segment des Drahtelements (6) und das Chip-Element (1) gebildet ist, um die Achse des Drahtelements (6) vergleichmäßigt wird.

11. Verfahren nach einem der vorhergehenden Anspruche, **dadurch gekennzeichnet, dass** der Schritt der Materialzufuhr vor dem Lagem des Drahtelements (6) in der Lagervorrichtung (18) durchgerührt wird.

12. Verfahren nach einem der Ansprüche 1 bis 10, dadurch gekenntzeichnet, dass vor dem Schritt der Materialzufuhr ein Schritt zum Lagern des Drahtelements (6), an dem wenigstens ein Chip-Element (1) befestigt ist, in der Lagervorrichtung (18) durchgerührt wird.

13. Anlage zum Durchführen eines Verbindens eines Elements mit Mikroelektronikchip (1) mit einem elektrisch leitenden Drahtelement (6), **dadurch gekennzeichnet, dass** sie umfasst:
- einen Behälter (7) der vereinzelte und getrennte Chip-Elemente (1) enthält, wobei jedes Chip-Element eine Anschlussklemme (3) umfasst, wobei die Anschlussklemme (3) eines jeden Chip-Elements (1) einen frei zugänglichen Scheitel aufweist, gegenüber dem kein Teil des Chip-Elements (1) vorhanden ist,
- ein System (8), um ein Drahtelement (6) von einer Vorrichtung zum Zuführen (16) eines Drahtelements (6) in Richtung einer Vorrichtung zum Lagern (18) des Drahtelements (6) ablaufen zu lassen, so dass das Drahtelement (6) einen Verbindungsbereich (Z1) durchläuft,
- eine Vorrichtung (9), um ein Chip-Element (1) aus dem Behälter (7) selektiv in den Verbindungsbereich (Z1) zuzuführen,
- eine Vorrichtung (14), um in dem Verbindungsbereich (Z1) das Drahtelement (6) an der Anschlussklemme (3) des Chip-Elements (1) zu befestigen,
- eine Vorrichtung (10), um auf dem Chip-Element (1), nach dessen Befestigung an dem Drahtelement (6), ein elektrisch isolierendes Material abzuschneiden, um eine Kappe (13) im Bereich der Befestigung zwischen dem Drahtelement (6) und der Anschlussklemme (3) auszubilden,
**dadurch gekennzeichnet, dass** die Anlage eine Vorrichtung zum Spannen des Drahtelements (6) umfasst, um das Drahtelement zwischen der Zuführvorrichtung (16) und der Lagervorrichtung (18) zu spannen.

14. Anlage nach Anspruch 13, **dadurch gekennzeichnet, dass** die Befestigungsvorrichtung (14) ein Element (14a, 14b) umfasst, das geeignet ist, das Drahtelement (6) in dem Verbindungsbereich (Z1) zu erhitzen, um das Befestigen zu vollziehen.

15. Anlage nach einem der Ansprüche 13 bis 14, **dadurch gekennzeichnet, dass** die Abscheidungsvorrichtung (10) eine Spritzdüse (12) umfasst, die dazu ausgelegt ist, eine Spritzposition einzunehmen, in der sie gegenüber der Seite des Chip-Elements (1) angeordnet ist, auf der die Kappe (13) ausgebildet werden soll.

## Claims

1. A method for assembling a microelectronic chip element (1) on an electrically conducting wire element (6), **characterized in that** it comprises the following steps:
• providing a transfer system of the wire element (6) from a wire element supply device (16) to a storage device (18) of said wire element (6),
• stretching of the wire element between the supply device (16) and the storage device (18) by a tensioning device (16, 18),
• providing (E1) a reservoir (7) of individualized and separated chip elements (1), each chip element (1) comprising a connection terminal (3), the connection terminal (3) of each chip element (1) comprising a top with free access facing which no part of the chip element (1) is present,
• transporting (E2) a chip element (1) from the reservoir (7) to an assembly area (Z1) located between the supply device (16) and storage device (18) in such a way that the wire element (6) is tightly stretched in said assembly area (Z1),
• fixing (E3) the electrically conducting wire element (6) to the connection terminal (3) of the chip element (1) in the assembly area (Z1),
• performing addition of electrically insulating material on the chip element (1) after the latter has been fixed to the wire element (6) to form a cover (13), said addition of material being performed on the surface of the chip element (1) comprising the connection terminal (3) fixed to said wire element (6) so as to cover at least the connection terminal (3) and a portion of the wire element (6) at the fixing point of the latter.

2. The method according to claim 1, **characterized in that** several chip elements (1) are selectively transported from the reservoir (7) one after the other to the assembly area (Z₁) so as to obtain, after a series of chip elements (1) has passed through the assembly area (Z1), a daisy chain formed by the series of chip elements (1) fixed to the wire element (6) and spaced out along the wire element (6).

3. The method according to one of claims 1 to 2, **characterized in that** the addition of material designed to form the cover (13) is performed by a nozzle (12) configured to provide a jet of the electrically insulating material.

4. The method according to one of the foregoing claims, **characterized in that** the fixing step of a chip element (1) to the wire element (6) is performed by sticking.

5. The method according to one of claims 1 to 3, **characterized in that** the fixing step of a chip element (1) to the wire element (6) is performed by welding.

6. The method according to one of the foregoing claims, **characterized in that** the connection terminal (3) of the chip element (1) comprises:
- a bump (4) making the electric connection with the chip of the chip element (1),
- a material (5) different from the bump (4) and covering the top of said bump (4),
and **in that** the fixing step of the wire element (6) is performed by modification of said material (5) at the top of the bump (4) to perform fixing thereof, and at least partially ensure the electric contact between the bump (4) and the wire element (6).

7. The method according to claims 5 and 6, **characterized in that** the material (5) at the top of the bump (4) wets an external surface of the wire element (6) during the welding step.

8. The method according to claims 4 and 6, **characterized in that** the material (5) at the top of the bump (4) is a polymer charged with electrically conducting particles, and **in that** the fixing step comprises mechanical stressing (F2) between the wire element (6) and said polymer so as to compress it between the wire element (6) and the bump (4) to make an electric contact between the bump (4) and the wire element (6) by pinching of an electrically conducting particle of the polymer, or of a cluster of electrically conducting particles of the polymer.

9. The method according to one of claims 7 or 8, **characterized in that**, during the fixing step of the wire element (6) onto the connection terminal (3), it comprises securing of the wire element (6) against the material (5) by biasing said wire element (6) in the direction of the bump (4) and heating the wire element (6) to soften the material (5).

10. The method according to any one of the foregoing claims, **characterized in that** the addition of material is calculated so as to homogenize, after the fixing step, the volume of the assembly formed by the cover (13), the segment of the wire element (6) sunk in the cover (13) and the chip element (1) around the axis of the wire element (6).

11. The method according to any one of the foregoing claims, **characterized in that** the material addition step is performed before the wire element (6) is stored in the storage device (18).

12. The method according to any one of claims 1 to 10, **characterized in that** a storage step of the wire element (6), on which at least one chip element (1) is fixed, in the storage device (18) is performed before the material addition step.

13. An installation for performing assembly of a microelectronic chip element (1) on an electrically conducting wire element (6), **characterized in that** it comprises:
- a reservoir (7) containing individualized and separated chip elements (1), each chip element comprising a connection terminal (3), the connection terminal (3) of each chip element (1) comprising a top with free access facing which no part of the chip element (1) is present,
- a transfer system (8) for running a wire element (6) from a wire element supply device (16) to a storage device (18) of said wire element (6) so that the wire element (6) passes through an assembly area (Z1),
- a device (9) to selectively transport a chip element (1) from the reservoir (7) to the assembly area (Z1),
- a device (14) for fixing the wire element (6) to the connection terminal (3) of said chip element (1), in the assembly area (Z1),
- a device (10) for depositing an electrically insulating material on the chip element (1) after fixing of the latter to the wire element (6) so as to form a cover (13) at the location of the fixing between the wire element (6) and the connection terminal (3)
**characterized in that** the installation comprises a tensioning device of the wire element (6) to stretch the wire element between the supply device (16) and the storage device (18).

14. The installation according to claim 13, **characterized in that** the device (14) for fixing comprises an element (14a, 14b) designed to heat the wire element (6) in the assembly area (Z1) to perform fixing.

15. The installation according to one of claims 13 to 14, **characterized in that** the device (10) for depositing comprises a projection nozzle (12) configured to occupy a projection position in which it is arranged facing the surface of the chip element (1) on which the cover (13) has to be formed.
